# EUROPÄISCHE PATENTSCHRIFT

(11) **EP 3 633 453 B1**
(45) Veröffentlichungstag und Bekanntmachung des Hinweises auf die Patenterteilung: **27.12.2023**
(21) Anmeldenummer: 18198459.2
(22) Anmeldetag: 03.10.2018
(51) Int. Cl.: G03F 7/00

(54) **VERFAHREN ZUR HERSTELLUNG VON (SUB-)MIKROSTRUKTUREN AUF GEWÖLBTEN FLÄCHEN EINES OPTISCHEN BAUTEILS**
METHOD FOR THE PREPARATION OF (SUB)-MICROSTRUCTURES ON CURVED SURFACES OF AN OPTICAL COMPONENT
PROCÉDÉ DE FABRICATION DE (SOUS) MICROSTRUCTURES SUR DES SURFACES TISSÉES D'UN COMPOSANT OPTIQUE

(43) Veröffentlichungstag der Anmeldung: 08.04.2020
(73) Patentinhaber: ZKW Group GmbH, 3250 Wieselburg (AT)
(72) Erfinder: Gürtl, Josef, 3233 Kilb (AT)
(74) Vertreter: Patentanwaltskanzlei Matschnig & Forsthuber OG

(56) Entgegenhaltungen:
- EP-A1- 3 093 709
- EP-A1- 3 238 912
- WO-A1-2018/011208
- KR-A- 20140 010 386
- US-A1- 2013 214 452
- US-A1- 2015 048 048
- XIA Y ET AL: "SOFT LITHOGRAPHY", ANGEWANDTE CHEMIE, INTERNATIONAL EDITION,, Bd. 37, 1. Januar 1998 (1998-01-01), Seiten 551-575, XP000985399, ISSN: 1433-7851, DOI: 10.1002/(SICI)1521-3773(19980316)37:5<550: :AID-ANIE550>3.0.CO;2-G

## Beschreibung

Die Erfindung betrifft ein Verfahren zur Herstellung von (Sub-)Mikrostrukturen auf gewölbten Flächen eines optischen Bauteils. Im Rahmen der vorliegenden Erfindung werden unter dem Begriff einer Mikrostruktur jene Strukturen verstanden, deren charakteristische Abmessungen im Mikrometer-Maßstab von einem Mikrometer (µm) bis zu wenigen Mikrometer (µm) groß sind. Unter Sub-Mikrostrukturen ist im Folgenden zu verstehen, dass die betreffenden Strukturen charakteristische Abmessungen aufweisen, die kleiner als ein Mikrometer (µm) sind und folglich im Sub-Mikrometer-Maßstab liegen. Folglich sind mit dem Begriff einer Sub-Mikrostruktur auch Strukturen mit charakteristischen Abmessungen bzw. mit Strukturgrößen von mehreren Nanometern (nm) mitumfasst. Im Folgenden wird unter dem Begriff Nanostrukturen verstanden, dass die betreffenden Strukturen charakteristische Längenabmessungen im Nanometer-Maßstab aufweisen, die im Wesentlichen im Bereich von mehreren Nanometern bis zu Zehntel-Nanometer liegen.

Die im Folgenden gewählte Schreibweise von (Sub-)Mikrostrukturen soll darauf hinweisen, dass derartige Strukturen charakteristische Abmessungen aufweisen, die jedenfalls im Mikrometer-Maßstab liegen und meist einige wenige Mikrometer, bevorzugt jedoch kleiner als ein Mikrometer, groß sind. Definitionsgemäß sind von dem hier gewählten Begriff der (Sub-)Mikrostrukturen somit auch Strukturen im Nanometer-Maßstab mitumfasst. Im Gegensatz dazu wird im Folgenden der Begriff von Makrostrukturen für diejenigen Strukturen gewählt, die deutlich größere charakteristische Abmessungen beispielsweise im Millimeter (mm)- oder aber im Zentimeter (cm)-Maßstab aufweisen.

(Sub-)Mikrostrukturen auf dreidimensionalen Makrooptiken bieten in letzter Zeit zahlreiche neue Anwendungsmöglichkeiten beispielsweise in den Bereichen der Optoelektronik, Photonik oder Bildverarbeitungssensorik. Die Kombination verschiedener optischer Funktionen auf einem einzigen Element kann wesentlich zur Miniaturisierung der optischen Komponenten, einer besseren Integration im System und zu niedrigeren Preisen beitragen. Die Entwicklung von neuartigen komplexen dreidimensionalen 3D-optischen Systemen, bei denen Mikro- bzw. Sub-Mikrostrukturen auf Makrostrukturen angeordnet sind, bringen allerdings zahlreiche Herausforderungen hinsichtlich der Gestaltung und der Fertigung mit sich.

Aus dem Stand der Technik sind bereits seit längerem etablierte Methoden bekannt, mit denen Mikrostrukturierungen auf planaren Substraten wie beispielsweise Silizium-Wafern gefertigt werden können. Beispielhaft sei dazu auf das sogenannte LIGA-Fertigungsverfahren hingewiesen, wobei das deutsche Akronym LIGA für die Verfahrensschritte: Lithographie, Galvanik und Abformung steht. Bei diesem Verfahren wird mittels einer Kombination von Tiefenlithographie, Galvanik und Mikroabformung die Herstellung von Mikrostrukturen mit Abmessungen beispielsweise bis in den Zehntel-Mikrometer-Maßstab, Strukturhöhen bis etwa 3 mm und einem Aspekt-Verhältnis bis etwa 50 bei Einsatz der Materialien Kunststoff, Metall oder Keramik ermöglicht. Nachteilig an diesem LIGA-Verfahren ist zumindest, dass das Ausgangsmaterial ein ebenes, planares Substrat, beispielsweise ein Siliziumwafer oder eine polierte Scheibe aus Metall oder aus einem anderen harten Material sein muss.

(Sub-)Mikrostrukturen auf ebenen, planaren Substraten werden meist mittels direkter Strukturierungsmethoden wie beispielsweise Laser-, Ionen- oder Elektronenstrahllithographie erzeugt. Beispielsweise ist aus der Druckschrift US 2007/0104813 A1 ein lithographisches Herstellungsverfahren zum Prägen flacher Bauteile, beispielsweise von integrierten Schaltkreisen (englisch: integrated circuit, kurz: IC) bekannt geworden, bei dem eine Stempeldruckvorlage mittels Nanoprägelithographie (englisch: nano imprint lithography, kurz: NIL) vorbereitet wird. Zwischen der Stempeldruckvorlage und dem zu prägenden Bauteil wird eine Fotoresistfilm-Schicht beispielsweise mittels Dispense-Verfahren aufgetragen und entsprechend verteilt. Anschließend wird die Stempeldruckvorlage in eine Vorrichtung über den zu strukturierenden Bauteil gelegt und der Fotoresistfilm mittels der Stempeldruckvorlage geprägt. Danach wird die Fotoresistfilm-Schicht durch UV-Licht gehärtet und abschließend wird in einem zweistufigen Ätzverfahren das Aspekt-Verhältnis der abgeformten Strukturen etwas vergrößert.

US 2015/048048 A1 beschreibt ein Verfahren zur Erzeugung von Strukturen auf gekrümmten Oberflächen von Substraten. Für die Erzeugung dieser Strukturen wird ein Präge-Verfahren unter Verwendung eines elastischen strukturierten Films als Präge-Stempel herangezogen. Bei den gekrümmtem Oberflächen kann es sich um Oberflächen von optischen Bauteilen handeln.

Die Anwendung dieser Methoden zur Mikro-Strukturierung für nicht-planare Oberflächen von dreidimensionalen Objekten ist allerdings äußerst komplex und erfordert zumindest eine spezielle Adaptierung von bestehenden Herstellungsanlagen sowie neuartige Herstellungsstrategien. Weiters ist von Nachteil, dass mit den bisher bekannt gewordenen lithographischen Verfahren nur geprägte Strukturen mit harten Konturübergängen und starren Flanken hergestellt werden können. Zur Herstellung optischer Strukturen für bestimmte optische Anwendungen wie beispielsweise Anti-Reflex-Strukturen auf optischen Bauteilen kann jedoch die Strukturierung sanfter, gleichmäßiger Konturübergänge erforderlich sein, welche mit lithographischen Verfahren insbesondere auf dreidimensionalen Bauteilen nicht oder nur in unzureichender Qualität hergestellt werden können.

Im Bereich der Optik ist es jedoch für die Miniaturisierung von leistungsfähigen Optiken erforderlich, mikrooptische, also beispielsweise diffraktive, refraktive und/oder reflektive Strukturen auf makroskopischen optischen Bauteilen, beispielsweise auf optischen Linsen, zu integrieren.

Um für den sichtbaren Spektralbereich wirksame mikrooptische Elemente zu realisieren, kann für einzelne Anwendungen die Verwendung von minimalen Strukturgrößen bis in den Sub-Mikrometer-Maßstab bzw. Nanometer-Maßstab notwendig sein.

Die Kombination von Makro- und (Sub-)Mikrooptiken auf ein und demselben Werkstück beispielsweise einer optischen Komponente ist allerdings generell eine große Herausforderung, die darin begründet ist, dass die Anforderungen an die Genauigkeit der (Sub-)Mikro-Strukturform, der Strukturgröße im (Sub-)Mikrometerbereich und insbesondere an die Oberflächenqualität im Nanometerbereich der optischen Komponenten sehr hoch angesetzt sind. Bereits eine geringfügige Abweichung von Form oder Große einer Komponente oder eine nicht optisch glatte Oberfläche kann zu einer deutlichen Verschlechterung der optischen Funktionalität des gesamten optischen Bauteils führen.

Die Fertigung von komplexen submikrooptischen Strukturen auf gekrümmten Oberflächen - beispielsweise mit Krümmungsradien kleiner als 50 mm - von 3D-Makrooptiken ist nach dem Wissensstand der Anmelderin bisher weder mittels direkter Laserstrahllithographie, noch mit sogenannten Top-Down-Methoden wie der Soft- und UV-Nano-Imprint-Lithographie möglich.

Die klassischen Techniken für die Fertigung der Makrooptiken sind unter anderem das Schleifen und Fräsen, die meist nur zur Fertigung vergleichsweise großer Optiken im Zentimeterbereich mit relativ einfachen Formen (beispielsweise für eine rotationssymmetrische Linse oder einen Konvexspiegel) geeignet sind. Die Fertigungszeit ist zudem recht lang, was ein iteratives und schnelles Prototyping verhindert. Deswegen existiert hier ebenfalls ein Bedarf für eine alternative effiziente Fertigung von 3D-Makrooptiken.

3D-Druck Technologie bietet neben einer hohen Flexibilität beim Design weiters die Möglichkeit, komplexe 3D-Makroobjekte zu fertigen sowie kosteneffektives Rapid-Prototyping durchzuführen. Allerdings entspricht die Oberflächenqualität von 3D-Druckerzeugnissen bis dato nicht den hohen Anforderungen für optische Anwendungen.

Im Lichte der zuvor angeführten Nachteile aus dem bekannten Stand der Technik besteht daher ein dringender Bedarf für ein verbessertes und effizientes Verfahren zur Herstellung von (Sub-)Mikrostrukturen auf gewölbten Flächen von optischen Bauteilen.

Dieses neuartige Herstellungsverfahren soll eine große Flexibilität in der Fertigung der jeweils benötigten Strukturformen und Strukturgrößen aufweisen, um Strukturen sowohl im Mikrometer- als auch im Sub-Mikrometer-Maßstab auf gekrümmten Oberflächen von größeren dreidimensionalen optischen Bauteilen wie beispielsweise von optischen Linsen von Kraftfahrzeugscheinwerfern mit höchstmöglicher Präzision und Abbildungstreue der Originalstrukturen eines Modellobjekts abzubilden bzw. zu übertragen.

Überdies besteht Bedarf an hochpräzisen optischen Bauteilen mit (Sub-)Mikrostrukturen, welche in gleichbleibender hoher Qualität ihrer (Sub-)Mikrostrukturen kostengünstig hergestellt werden können. Insbesondere besteht im Bereich der optischen Bauteile der Bedarf, optische Komponenten herstellen zu können, die definierte optische Eigenschaften wie beispielsweise reflexionshemmende Eigenschaften ausschließlich aufgrund ihrer Strukturierung aufweisen, ohne dazu beispielsweise eine herkömmliche Anti-Reflex-Beschichtung zu benötigen.

Es ist somit eine der Aufgaben der vorliegenden Erfindung ein Verfahren zur Herstellung von (Sub-)Mikrostrukturen auf gewölbten Flächen eines optischen Bauteils bereitzustellen, das die geschilderten Nachteile des Standes der Technik vermeidet.

Erfindungsgemäß wird diese Aufgabe bei einem gattungsmäßigen Verfahren zur Herstellung von (Sub-)Mikrostrukturen auf gewölbten Flächen eines optischen Bauteils durch die im kennzeichnenden Teil des Patentanspruchs 1 angegebenen Verfahrensschritte gelöst. Besonders bevorzugte Ausführungsformen und Weiterbildungen der Erfindung sind Gegenstand der Unteransprüche.

Das erfindungsgemäße Verfahren zur Herstellung von (Sub-)Mikrostrukturen auf gewölbten Flächen eines optischen Bauteils umfasst die folgenden Verfahrensschritte:
- -a-: Bereitstellen einer elastischen Trägerfolie mit einer von der Trägerfolie ablösbaren Verstärkungsfolie;
- -b-: Bereitstellen eines Modellobjekts mit einer (Sub-)Mikrostruktur;
- -c-: Auftragen eines Abformfilms auf einer der Verstärkungsfolie abgewandten Vorderseite der Trägerfolie;
- -d-: Abformen der (Sub-)Mikrostruktur des Modellobjekts auf die mit dem Abformfilm beschichtete Vorderseite der Trägerfolie unter Bildung eines strukturierten Abformfilms;
- -e-: Einspannen der mit dem strukturierten Abformfilm beschichteten Trägerfolie samt der Verstärkungsfolie in einem Halterahmen;
- -f-: Auftragen eines aushärtbaren Übertragungsfilms auf die mit dem strukturierten Abformfilm beschichtete Vorderseite der Trägerfolie;
- -g-: Ablösen der Verstärkungsfolie von der Rückseite der Trägerfolie;
- -h-: Anpressen zumindest eines Oberflächenabschnittes eines zu strukturierenden optischen Werkstücks auf den mit dem Übertragungsfilm beschichteten strukturierten Abformfilm an der Vorderseite der Trägerfolie unter Bildung eines strukturierten Übertragungsfilms;
- -i-: Aushärten des an dem zumindest einen Oberflächenabschnitt des optischen Werkstücks anhaftenden strukturierten Übertragungsfilms unter Bildung eines mit (Sub-)Mikrostrukturen strukturierten optischen Bauteils;
- -j-: Abnehmen des strukturierten optischen Bauteils von dem auf der Trägerfolie verbleibenden strukturierten Abformfilm.

Das erfindungsgemäße Herstellungsverfahren bietet somit den Vorteil, dass ein makroskopischer dreidimensionaler optischer Bauteil mit gewölbten Flächen bzw. Oberflächen, welcher als Ausgangsmaterial im Sinne eines Werkstücks oder eines Rohlings bereit gestellt wird und der Makrostrukturen und charakteristische Längenabmessungen im Millimeter (mm)- und/oder im Zentimeter (cm)-Maßstab aufweist, mit mikrooptischen (Sub-)Mikrostrukturen im Mikrometer (µm)- und/oder im Nanometer (nm)-Maßstab strukturiert werden kann.

Diese (Sub-)Mikrostrukturen bzw. Nanostrukturen sind dabei eine exakte, formgetreue Abformung der (Sub-)Mikrostrukturen des verwendeten Modellobjekts.

Zweckmäßig wird gemäß Verfahrensschritt -a- zuerst eine hochelastische Trägerfolie mit einer von der Trägerfolie ablösbaren Verstärkungsfolie bereitgestellt. Der zumindest zweilagige Folienaufbau der Trägerfolie samt der von dieser ablösbaren Verstärkungsfolie hat den Vorteil, dass bei Durchführung der folgenden Verfahrensschritte -c- bis -f-, bei denen zuerst ein Abformfilm und nach dem Strukturieren des Abformfilmes auf diesem ein weiterer Übertragungsfilm aufgetragen werden, die Trägerfolie von der darunterliegenden Verstärkungsfolie entsprechend verstärkt wird. Die Verstärkungsfolie ist dabei möglichst unelastisch und bildet eine belastbare Unterlage für die elastische Trägerfolie.

Um den Vorteil der hochelastischen Trägerfolie während des Abformens des strukturierten Übertragungsfilms auf die Oberfläche bzw. auf einen Oberflächenabschnitt des zu strukturierenden optischen Werkstücks nutzen zu können, wird nach dem Einspannen der Trägerfolie in einen Halterahmen gemäß Verfahrensschritt -e- sowie nach dem anschließenden Auftragen des aushärtbaren Übertragungsfilms gemäß Verfahrensschritt -f-im nachfolgenden Verfahrensschritt -g- die Verstärkungsfolie von der vom Übertragungsfilm sowie Abformfilm abgewandten Rückseite der Trägerfolie abgelöst.

Gemäß Verfahrensschritt -b- wird ein Modellobjekt mit der abzuformenden bzw. zu übertragenden (Sub-)Mikrostruktur bereitgestellt. Je nach Anforderung kann das Modellobjekt als Einweg-Stempel oder Einweg-Prägewerkzeug für jeden Strukturierungsvorgang jeweils neu bereitgestellt werden. Alternativ dazu ist es im Rahmen des erfindungsgemäßen Verfahrens vorgesehen, dass das Modellobjekt aus einem robusten, abriebfesten und formstabilen Material, beispielsweise aus Metall, hergestellt wird, und mehrfach für eine Mehrzahl von Strukturierungsvorgängen eingesetzt werden kann. Vorzugsweise ist das Modellobjekt im Wesentlichen eben bzw. plan und es können die mikrooptischen (Sub-)Mikrostrukturen somit besonders exakt und vergleichsweise einfach auf einem flächigen 2D-Modellobjekt hergestellt werden. Diese (Sub-)Mikrostrukturen des Modellobjekts bilden eine Positivform der (Sub-)Mikrostruktur des späteren fertigen Produkts, also des strukturierten optischen Bauteils. Für den Fall, dass mehrere Oberflächenabschnitte des zu strukturierenden optischen Werkstücks strukturiert werden sollen oder aber für Werkstücke, welche Kanten zwischen zu strukturierenden gewölbten Oberflächenabschnitten aufweisen, können auch mehrere Modellobjekte zum Strukturieren des optischen Bauteils erforderlich sein.

Im Verfahrensschritt -d- wird durch die Abformung der (Sub-)Mikrostruktur des Modellobjekts auf die mit dem Abformfilm beschichtete Vorderseite der Trägerfolie eine Negativform der (Sub-)Mikrostruktur in den Abformfilm abgeformt bzw. eingeprägt.

Diese Negativform der (Sub-)Mikrostruktur im strukturierten Abformfilm wird im Verfahrensschritt -f- als Positivform auf den aufgetragenen aushärtbaren Übertragungsfilm übertragen.

In den beiden Verfahrensschritten -h- und -j- wird sodann der strukturierte Übertragungsfilm mit der Positivform der mikrooptischen (Sub-)Mikrostruktur auf den Rohling des zu strukturierenden optischen Werkstücks durch Anpressen und anschließendes Aushärten des strukturierten Übertragungsfilms übertragen.

Der Übertragungsfilm ist dabei vorzugsweise aus einer flüssigen bzw. fließfähigen sowie unter UV-Licht-Einwirkung transparent aushärtbaren UV-Substratmasse hergestellt. In diesem beispielhaften Fall erfolgt das Aushärten somit unter Einwirkung von UV-Licht gegebenenfalls bei über der Raumtemperatur erhöhter Temperatur. Zweckmäßig sind die verwendete Trägerfolie sowie der Abformfilm jeweils aus einem UV-Licht durchlässigen, transparenten Material hergestellt, da während des Aushärtens der Abformfilm als Formkörper für den Übertragungsfilm noch auf der Trägerfolie aufliegt. Um eine rasche Aushärtung des aufgetragenen Übertragungsfilms auf einem oder mehreren Oberflächenabschnitten des optischen Werkstücks zu erzielen, soll es daher auch von der Rückseite der Trägerfolie aus möglich sein, den Übertragungsfilm mit UV-Licht zu härten.

Ebenso ist es im Rahmen der Erfindung vorgesehen, Materialien für den Übertragungsfilm auszuwählen, die unter Druck- und/oder unter Temperatureinfluss aushärtbar sind.

Die Reihenfolge einzelner Verfahrensschritte kann erforderlichenfalls variiert werden. So ist es beispielsweise möglich, die Abfolge der beiden Verfahrensschritte -a- und -b- zu tauschen. Die weiteren Verfahrensschritte -c- bis -j- werden zweckmäßig in der angegebenen Reihenfolge durchgeführt.

Vorteilhaft kann bei einem erfindungsgemäßen Verfahren die elastische Trägerfolie samt der daran ablösbar angeordneten Verstärkungsfolie als Rollenware bereitgestellt werden. In dieser Verfahrensvariante ist es möglich, das Herstellungsverfahren semi-kontinuierlich durchzuführen und die elastische Trägerfolie wie ein Förderband in kurzen Abständen bzw. mit kurzen Unterbrechungen mit den entsprechenden Abformfilmen sowie Übertragungsfilmen zu beschichten. Solcherart können rasch hintereinander optische Werkstücke mit den entsprechenden strukturierten Übertragungsfilmen beschichtet zu den fertig strukturierten optischen Bauteilen angefertigt werden. Die Trägerfolie und die Verstärkungsfolie können dabei wahlweise jeweils als einzelne, getrennte Rollen bereitgestellt werden, wobei in diesem Fall in einem vorbereitenden Verfahrensschritt die Trägerfolie sowie die Verstärkungsfolie zur Unterstützung der Trägerfolie miteinander verbunden werden. Oder aber es wird eine gemeinsame Rollenware bereit gestellt, wobei die elastische Trägerfolie samt der daran ablösbar angeordneten Verstärkungsfolie bereits miteinander verbunden bzw. aneinander liegend gemeinsam aufgerollt sind. Die Trägerfolie sowie die an der Rückseite der Trägerfolie angeordnete Verstärkungsfolie werden dabei vorzugsweise in horizontaler Lage geführt.

Zweckmäßig können bei einem Verfahren gemäß der Erfindung die Verstärkungsfolie und die Trägerfolie nach Gebrauch getrennt voneinander aufgerollt und gegebenenfalls wiederverwendet werden. Diese Verfahrensvariante ist besonders wirtschaftlich und es kann unnötiger Abfall vermieden werden, indem gegebenenfalls die Verstärkungsfolie und/oder die Trägerfolie wiederverwendet werden können.

In einer besonders vorteilhaften Ausführung der Erfindung kann bei einem Verfahren die elastische Trägerfolie aus einem Silikonkautschuk-Material, vorzugsweise aus Polydimethylsiloxan, gefertigt sein. Diese Verfahrensvariante bietet den Vorteil, dass eine Trägerfolie aus einem Silikonkautschuk-Material besonders elastisch ist und das Anpressen des Übertragungsfilms an der Oberfläche des zu strukturierenden optischen Werkstücks daher besonders gleichmäßig und schonend erfolgen kann. Insbesondere für komplex geformte optische Werkstücke mit stark gewölbten Oberflächenabschnitten ist der Einsatz solcher Trägerfolien zur Abformung des strukturierten Übertragungsfilms besonders zweckmäßig. Trägerfolien aus Polydimethylsiloxan (kurz PDMS) haben hervorragende Materialeigenschaften aufgrund ihrer geringen Shorehärte von etwa 20-35 ShoreA sowie ihrer hohen Elastizität von 400% und darüber. Je nach Anwendungsfall stehen solche Trägerfolien mit Materialstärken beispielsweise von 20 µm bis 400 µm zur Verfügung und können beispielsweise vom Hersteller Wacker unter den Markennamen Elastosil^{®} oder Silpuran^{®} erworben werden.

Besonders vorteilhaft kann bei einem erfindungsgemäßen Verfahren das Modellobjekt zumindest in seinem mit der (Sub-)Mikrostruktur versehenen Konturabschnitt im Wesentlichen eben sein. Das Anfertigen von (Sub-)Mikrostrukturen im Mikrometer-und/oder Nanometer-Maßstab ist auf einem ebenen Modellobjekt als Strukturträger wesentlich einfach herzustellen als auf einem dreidimensional gewölbten bzw. gekrümmten Modellobjekt. Auch das weitere Abformen und Übertragen der (Sub-)Mikrostruktur ist mit einem im Wesentlichen ebenen bzw. planaren Modellobjekt einfacher, da dieses wie ein Prägestempel gehandhabt werden kann. In diesem Zusammenhang wird der hier verwendete Ausdruck "im Wesentlichen eben" bewusst gewählt, um für den Fachmann klar und eindeutig zu defirueren, dass jene Konturabschnitte des Modellobjekts, welche mit der Positivform der zu übertragenden (Sub-)Mikrostruktur gestaltet sind, in ihrer Makrostruktur zweidimensional eben bzw. flächig gestaltet sind. Selbstredend weisen jedoch diese Konturabschnitte die entsprechenden mikrooptischen (Sub-)Mikrostrukturen auf, sind also in ihrer Mikrostruktur nicht glatt, sondern entsprechend mikrostrukturiert gestaltet.

Zweckmäßig kann in einer Verfahrensvariante gemäß der Erfindung der Abformfilm aus einer Abformmasse enthaltend ein Silikonkautschuk-Material, vorzugsweise ein additionsvernetzendes Zwei-Komponenten- Silikonkautschuk-Material, gebildet werden. Ein solcher Abformfilm lässt sich vorteilhaft exakt und blasenfrei dosieren. Beispielsweise kann auch ein Abformfilm aus Polydimethylsiloxan (kurz PDMS) bzw. Polydimethylsiloxan (kurz PDMS) enthaltend eingesetzt werden.

Besonders zweckmäßig kann es sein, wenn das erfindungsgemäße Verfahren so geführt wird, dass die (Sub-)Mikrostruktur des Modellobjekts auf den Abformfilm geprägt wird, wobei das Aufprägen vorzugsweise während einer Zeitdauer von zumindest 30 Sekunden bei über der Raumtemperatur erhöhter Temperatur, besonders bevorzugt bei einer Temperatur von 70°C bis 140°C, erfolgt. Vorteilhaft härtet und vernetzt eine Abformmasse aus einem additionsvernetzenden Zwei-Komponenten- Silikonkautschuk-Material bei rund 80°C bis 120°C etwa während einer Minute zu einem entsprechend strukturierten Abformfilm, welcher wiederum als Model zur Aufnahme des Übertragungsfilms dient. Die Verstärkungsfolie auf der Rückseite der Trägerfolie dient dabei als Unterstützung.

In einer weiteren zweckmäßigen Verfahrensvariante kann das Anpressen des zumindest einen Oberflächenabschnittes des zu strukturierenden optischen Werkstücks auf den mit dem Übertragungsfilm beschichteten strukturierten Abformfilm durch Erzeugen von Überdruck an der Rückseite der Trägerfolie und/oder durch Erzeugen von Unterdruck, vorzugsweise durch Evakuieren, an der Vorderseite der Trägerfolie erfolgen. Das Anpressen des optischen Werkstücks auf den Übertragungsfilm sowie den darunter befindlichen Abformfilm, welche beide auf der Vorderseite bzw. der Oberseite der Trägerfolie angeordnet sind, erfolgt zweckmäßig im Wesentlichen lotrecht auf die gespannte Fläche der Trägerfolie. Durch das Aufbringen von Unterdruck auf der Rückseite der Trägerfolie und/oder durch das Erzeugen von Unterdruck an der Vorderseite der Trägerfolie wird das schonende Anpressen des zu strukturierenden optischen Werkstücks weiter verstärkt und vergleichmäßigt. Allfällige lokale Druckstellen beim Abformen können so erfolgreich vermieden werden.

So können beispielsweise durch Anlegen von Vakuum vertiefte Konturabschnitte auf der Oberfläche des optischen Werkstücks besonders exakt mit dem Übertragungsfilm strukturiert werden, da die Trägerfolie samt dem Abformfilm und dem Übertragungsfilm durch den herrschenden Unterdruck auch in solche vertieft liegenden Konturabschnitte eingesaugt und angepresst werden kann.

In einer weiteren bevorzugten Ausführungsvariante des erfindungsgemäßen Verfahrens kann das Aushärten des an dem zumindest einen Oberflächenabschnitt des optischen Werkstücks anhaftenden strukturierten Übertragungsfilms unter Einwirkung von UV-Licht vorzugsweise während einer Zeitdauer von zumindest 30 Sekunden bei über der Raumtemperatur erhöhter Temperatur, besonders bevorzugt bei einer Temperatur von 70°C bis 140°C, erfolgen. Wie eingangs bereits erwähnt hat der Einsatz eines Übertragungsfilms aus einer unter UV-Licht-Einwirkung aushärtbaren UV-Substratmasse den Vorteil, dass der Übertragungsfilm im flüssigen bzw. fließfähigen Zustand auf dem zuvor strukturierten Abformfilm aufgebracht werden kann und so die eingeprägte (Sub-)Mikrostruktur als Negativform des Abformfilms möglichst verlustfrei abgeformt wird.

Um diese Negativform der (Sub-)Mikrostruktur des Abformfilms in eine dauerhafte, haltbare Positivform des Übertragungsfilms umzuwandeln, wird der bereits strukturierte Übertragungsfilm anschließend unter UV-Licht-Einwirkung ausgehärtet. Um eine raschere Aushärtung zu ermöglichen, erfolgt die UV-Licht-Einwirkung vorzugsweise während einer Zeitdauer von zumindest 30 Sekunden bei einer erhöhten Temperatur oberhalb der Raumtemperatur. Besonders rasch erfolgt das Aushärten während dieser Zeitspanne bei einer weiter bevorzugten Temperatur von 70°C bis 140°C.

Zweckmäßig kann bei einem Verfahren gemäß der Erfindung der Übertragungsfilm aus einem unter UV-Licht-Einwirkung transparent aushärtenden Haftklebstoff, vorzugsweise aus einem flüssigen UV-Acrylat, gebildet werden. Ein solcher ausgehärteter Haftklebstoff weist eine gute Temperaturbeständigkeit sowie Beständigkeit gegen Chemikalien, Sonnenlicht sowie gegen Witterungseinflüsse auf. Weiters ist es mit einem solchen Haftklebstoff, vorzugsweise mit einem flüssigen UV-Acrylat-Klebstoff, möglich. Somit wird gewährleistet, dass die auf der Oberfläche des optischen Werkstücks aufgebrachten (Sub-)Mikrostrukturen, welche vom Übertragungsfilmmaterial gebildet werden, dauerhaft sind.

Durch das Verfahren kann ein optisches Bauteil bereitgestellt werden, dessen Grundkörper einerseits Makrostrukturen bzw. gekrümmte Oberflächenabschnitte mit charakteristischen Abmessungen beispielsweise im Millimeter (mm)- oder aber im Zentimeter (cm)-Maßstab aufweist, wobei der optische Bauteil andererseits an einem gekrümmten Oberflächenabschnitt eine vor definierte (Sub-)Mikrostruktur im Mikrometer- und/oder Nanometer-Maßstab aufweist.

Bei einem optischen Bauteil, das nach einem erfindungsgemäßen Verfahren hergestellt ist, ist zumindest auf einem gekrümmten Oberflächenabschnitt des optischen Bauteils ein mit einer (Sub-)Mikrostruktur strukturierter Übertragungsfilm aus einem ausgehärteten Haftklebstoff aufgebracht, wobei die (Sub-)Mikrostruktur des optischen Bauteils eine formgetreue Abformung eines Modellobjekts ist. Vorteilhaft können mit dem erfindungsgemäßen Verfahren formgetreue Abdrücke der (Sub-)Mikrostruktur des zweidimensionalen Modellobjekts als Positivform auf den dreidimensionalen optischen Bauteil übertragen werden. Der mit der abgeformten (Sub-)Mikrostruktur strukturierte Übertragungsfilm aus einem ausgehärteten Haftklebstoff haftet dauerhaft und formstabil an der gekrümmten Oberfläche des optischen Bauteils. Durch den Einsatz eines oder mehrerer Modellobjekte zum Abformen und Prägen der (Sub-)Mikrostruktur gelingt es, auf kostengünstige und rasche Weise strukturierte optische Bauteile in Serie anzufertigen, wobei die mikrostrukturierte (Sub-)Mikrostruktur jedes einzelnen optischen Bauteiles einer Serie im Wesentlichen mit höchstmöglicher Formtreue gleich strukturiert ist. Bestimmte optische Funktionen, die von der an der Oberfläche der optischen Bauteile angebrachten (Sub-)Mikrostruktur erfüllt werden sollen, können vorteilhaft daher von sämtlichen optischen Bauteilen einer Serienfertigung in gleich hoher Qualität erfüllt werden. Für höchstmögliche Präzision der abgeformten (Sub-)Mikrostruktur ist es denkbar, dass im Rahmen der Erfindung für jeden einzelnen optischen Bauteil jeweils ein unbenutztes Modellobjekt zur Strukturabformung eingesetzt wird. Ebenso ist es im Rahmen der Erfindung vorgesehen, dass ein Modellobjekt zur Strukturabformung in bestimmten Intervallen ausgetauscht oder gereinigt werden kann, um die formtreue Abformung und Übertragung der (Sub-)Mikrostruktur auf den optischen Bauteil gewährleisten zu können. Derartige Maßnahmen zur Qualitätssicherung einer Serienproduktion sind dem Fachmann allerdings hinlänglich bekannt.

Bei einem optischen Bauteil kann die (Sub-)Mikrostruktur des strukturierten Übertragungsfilms so konfiguriert sein, dass die (Sub-)Mikrostruktur eine Reflexion an einer optischen Oberfläche des optischen Bauteils unterdrückt. Besonders zweckmäßig können so Anti-Reflex-Strukturen an der Oberfläche eines optischen Bauteils abgeformt werden, ohne dass der Bauteil mit einer sonst meist üblichen Anti-Reflex-Beschichtung versehen werden muss. Die Reflexion-hemmenden bzw. -unterdrückenden Mikrostrukturen weisen dazu charakteristische Längen beispielsweise im Sub-Mikrometer-Maßstab auf und betragen vorzugsweise von rund 10 µm bis etwa 100 µm.

Bei einem optischen Bauteil kann die (Sub-)Mikrostruktur des strukturierten Übertragungsfilms als diffraktives optisches Element konfiguriert sein, wobei die (Sub-)Mikrostruktur zum Formen eines Lichtstrahlbündels und/oder zum Zerlegen eines Lichtstrahlbündels in mehrere Teillichtstrahlen gestaltet ist. Die typischen charakteristischen Längen einer solchen (Sub-)Mikrostruktur, die als diffraktives optisches Element dient, betragen meist unter 20 µm bis etwa 0,2 µm.

Überdies ist es möglich, mit der abgeformten (Sub-)Mikrostruktur an der Oberfläche des optischen Bauteils bestimmte Licht-Beugungseffekte und Farbeffekte erzielen zu können. Dazu werden Mikrostrukturen abgeformt, deren charakteristische Längen vorzugsweise größer als 100 nm, besonders bevorzugt größer als 500 nm, betragen.

Bei einem optischen Bauteil können an zumindest zwei gekrümmten Oberflächenabschnitten des optischen Bauteils jeweils mit (Sub-)Mikrostrukturen strukturierte Übertragungsfilme aus einem ausgehärteten Haftklebstoff aufgebracht sein, wobei die (Sub-)Mikrostrukturen der zumindest zwei gekrümmten Oberflächenabschnitte jeweils gleich gestaltet sind und/oder dieselbe optische Funktion aufweisen. Somit kann mit dem erfindungsgemäßen Verfahren beispielsweise auch die Vorder- und die Rückseite eines optischen Bauteils vergleichbar strukturiert werden.

In einer alternativen Ausführungsvariante können bei einem erfindungsgemäß hergestellten optischen Bauteil an zumindest zwei gekrümmten Oberflächenabschnitten des optischen Bauteils jeweils mit (Sub-)Mikrostrukturen strukturierte Übertragungsfilme aus einem ausgehärteten Haftklebstoff aufgebracht sein, wobei die (Sub-)Mikrostrukturen der zumindest zwei gekrümmten Oberflächenabschnitte jeweils unterschiedlich gestaltet sind und/oder unterschiedliche optische Funktionen aufweisen. Somit kann mit dem erfindungsgemäßen Verfahren beispielsweise auch die Vorder- und die Rückseite eines optischen Bauteils voneinander unterschiedlich strukturiert werden.

Weitere Einzelheiten, Merkmale und Vorteile der Erfindung ergeben sich aus der nachfolgenden Erläuterung von in den Zeichnungen schematisch dargestellten Ausführungsbeispielen. In den Zeichnungen zeigen:
- **Fig. 1** in einer schematischen Ablaufskizze die wesentlichen Verfahrensschritte bzw. Verfahrenseinheiten des erfindungsgemäßen Herstellungsverfahrens;
- **Fig. 2** im Detail die in Fig. 1 gezeigte Abwickelstation;
- **Fig. 3** im Detail die in Fig. 1 gezeigte Dosierstation für eine Abformmasse des Abformfilms;
- **Fig. 4** im Detail die in Fig. 1 gezeigte Prägestation;
- **Fig. 5** in einer Detailansicht die in Fig. 1 gezeigte Dosierstation für eine UV-Substratmasse des Übertragungsfilms;
- **Fig. 6** in einer Detailansicht die in Fig. 1 gezeigte Ablösestation;
- **Fig. 7** im Detail die in Fig. 1 gezeigte Übertragungsstation;
- **Fig. 7A** im Detail das Bestücken einer Übertragungsstation;
- **Fig. 7B** im Detail das Schließen der in Fig. 7A gezeigten Übertragungsstation;
- **Fig. 7C** im Detail das Abformen und Übertragen der (Sub-)Mikrostruktur auf den optischen Bauteil;
- **Fig. 7D** im Detail das Entleeren der Übertragungsstation;
- **Fig. 8** in einer Detailansicht die in Fig. 1 gezeigte Aufwickelstation;
- **Fig. 9** in einer isometrischen Ansicht schräg von oben einen mit (Sub-)Mikrostrukturen strukturierten optischen Bauteil kurz vor dem Abnehmen von der Trägerfolie;
- **Fig. 10** den in Fig. 9 gezeigten fertig strukturierten optischen Bauteil in einer Ansicht schräg von vorne nach dem Abnehmen von der Trägerfolie.

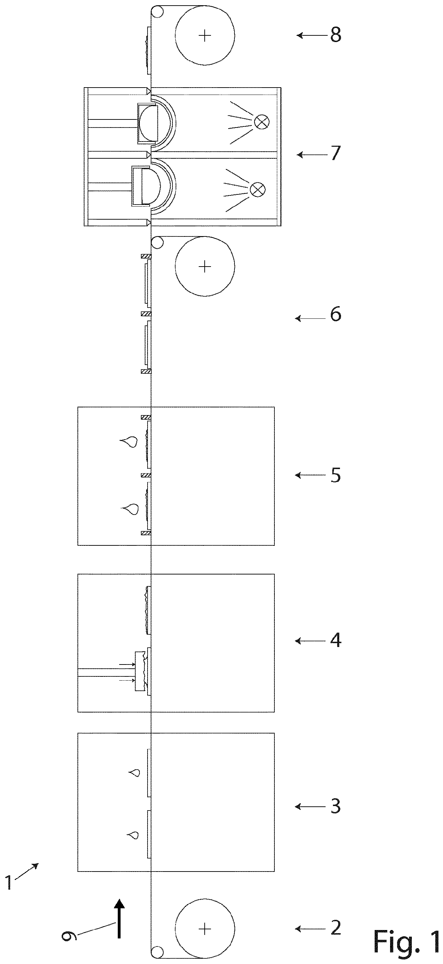

**Fig. 1** veranschaulicht die wesentlichen Verfahrensschritte bzw. Verfahrenseinheiten des erfindungsgemäßen Herstellungsverfahrens und zeigt eine Vorrichtung 1 zur erfindungsgemäßen Herstellung von (Sub-)Mikrostrukturen auf gewölbten Flächen eines optischen Bauteils. Die Vorrichtung 1 umfasst im Wesentlichen eine Abwickelstation 2, in der eine elastische Trägerfolie samt einer Verstärkungsfolie bereitgestellt werden, eine Dosierstation 3 für das Auftragen eines Abformfilms, eine Prägestation 4 zum Strukturieren des Abformfilms, eine Dosierstation 5 für den Auftrag eines Übertragungsfilms auf dem strukturierten Abformfilm, weiters eine Ablösestation 6, in der die Verstärkungsfolie von der Trägerfolie abgelöst wird, eine Übertragungsstation 7 sowie eine Aufwickelstation 8. Der Pfeil 9 symbolisiert die Transportrichtung 9, mit der die Vorrichtung 1 hier in semikontinuierlicher Betriebsweise beschickt wird.

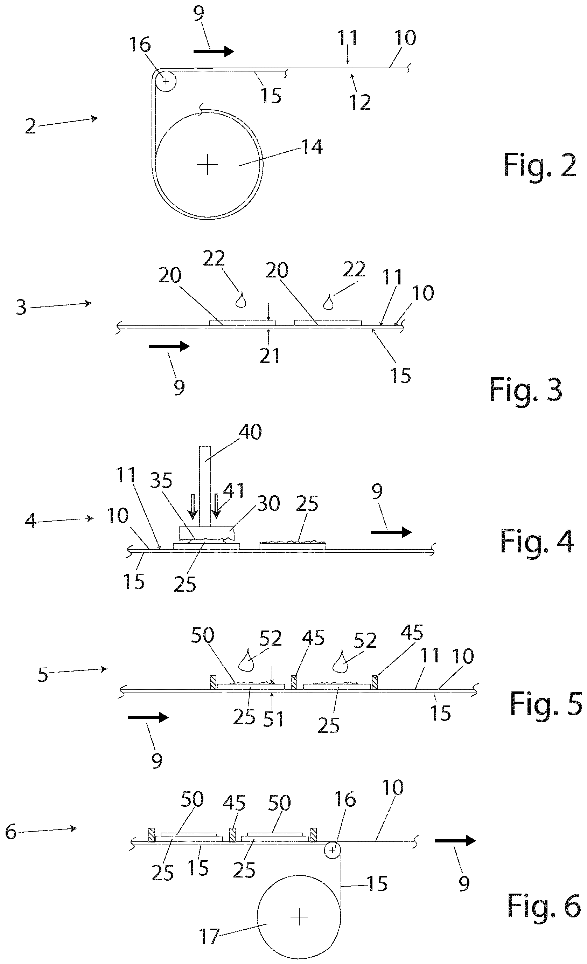

**Fig. 2** zeigt die Abwickelstation 2 im Detail. Der Pfeil 9 gibt wiederum die Transportrichtung 9 einer elastischen Trägerfolie 10 an, welche als Auflagefläche für die weiteren Schichten bzw. Bauteile dient. Die Trägerfolie 10 ist hier aus einem hochelastischen Silikonfilm aus Polydimethylsiloxan (kurz PDMS) hergestellt und weist eine Vorderseite 11 sowie eine der Vorderseite 11 abgewandte Rückseite 12 der Trägerfolie 10 auf. Die Trägerfolie 10 wird als Rollenware als Trägerfolienrolle 14 bereitgestellt.

An der Rückseite 12 der Trägerfolie 10 anliegend ist eine von der Trägerfolie 10 ablösbare Verstärkungsfolie 15 angebracht, die zur Stabilisierung und Erhöhung der Festigkeit der hochelastischen Trägerfolie 10 dient. Die Verstärkungsfolie 15 wird hier gemeinsam mit der Trägerfolie 10 auf der Trägerfolienrolle 14 bereitgestellt. Alternativ dazu kann die Verstärkungsfolie 15 auch separat auf einer eigenen Verstärkungsfolienrolle 17 bereitgestellt werden und erst in der Abwickelstation 2 in Kontakt mit der darüber angeordneten Trägerfolie 10 gebracht werden. Diese Verfahrensvariante des separaten Abwickelns zweier unterschiedlichen Folienmaterialien und gemeinsamen Transport als Folienverband ist in den Zeichnungen nicht explizit gezeigt, dem Fachmann jedoch bekannt.

Solange die Trägerfolie 10 auf der möglichst unelastischen Verstärkungsfolie 15 aufliegt, wird eine gute Planlage des Folienverbands bestehend aus der Trägerfolie 10 und der darunter angeordneten Verstärkungsfolie 15 gewährleistet. Die Trägerfolie 10 wird hier zweckmäßig so geführt, dass die Vorderseite 11 der Trägerfolie 10 auch deren Oberseite bildet, welche im Wesentlichen in horizontaler Transportrichtung 9 bewegt wird. Weiters ist in Fig. 2 noch eine Umlenkrolle 16 gezeigt.

**Fig. 3** zeigt im Detail die Dosierstation 3 für den Auftrag eines Abformfilms 20 mit einer Filmdicke 21 auf der Vorderseite 11 der Trägerfolie 10. In der Dosierstation 3 wird die Trägerfolie 10 von der Verstärkungsfolie 15, die an der Rückseite 12 der Trägerfolie 10 anliegt, unterstützt. Der Abformfilm 20 wird hier durch eine exakt und blasenfrei dosierbare Abformmasse 22 aus einem Zwei-Komponenten-Silikonkautschuk-Material gebildet.

**Fig. 4** stellt im Detail die Prägestation 4 dar, in der der Abformfilm 20 strukturiert wird und die Prägestation 4 als mit einem Abdruck einer (Sub-)Mikrostruktur strukturierter Abformfilm 25 verlässt. Dazu wird ein zuvor angefertigtes Modellobjekt 30 bereitgestellt, welches Modellobjekt 30 die Positivform einer mikrooptischen (Sub-)Mikrostruktur 35 trägt. Die Abform- bzw. Prägefläche des Modellobjekts 30 ist hier im Wesentlichen flächig eben und weist nur die besagte (Sub-)Mikrostruktur 35 im Mikrometer- und/oder Nanometer-Maßstab auf. Mit Hilfe einer Prägeeinrichtung 40, in die das vorbereitete Modellobjekt 30 als Träger der (Sub-)Mikrostruktur 35 eingespannt wird, wird diese (Sub-)Mikrostruktur 35 mittels eines lotrecht zur Trägerfolie 10 verfahrbaren Prägestempels durch Druckeinwirkung 41, welche als Pfeil 41 symbolisiert ist, auf den Abformfilm 20 abgeformt. Zweckmäßig erfolgt das Prägen des Abformfilms 20 hier während einer Zeitdauer von etwa einer Minute sowie bei einer erhöhten Temperatur von 80°C bis 120°C. Der solcherart strukturierte Abformfilm 25 ist nach dem Prägen bereits ausgehärtet und kann weiters als strukturierte Auftragsfläche für den nächsten Verfahrensschritt dienen.

Anschließend wird die mit dem strukturierten Abformfilm 25 beschichtete Trägerfolie 10 samt der darunter anliegenden Verstärkungsfolie 15 in einen Halterahmen 45 überführt und in diesem eingespannt. Dies dient bereits zur Vorbereitung eines später folgenden Verfahrensschrittes, in dem dann die Verstärkungsfolie 15 von der Trägerfolie 10 getrennt wird. Um die Trägerfolie 10 in den Halterahmen 45 überführen und in diesem einspannen zu können, ist es dazu wichtig, dass die Trägerfolie 10 noch in Planlage auf der Verstärkungsfolie 15 aufliegt.

**Fig. 5** zeigt in einer Detailansicht die nachfolgende Dosierstation 5 für den Auftrag eines Übertragungsfilms 50. Die Trägerfolie 10 samt der Verstärkungsfolie 15 sind bereits im Halterahmen 45 eingespannt. In der Dosierstation 5 erfolgt nun der dosierte Auftrag des Übertragungsfilms 50 mit einer Filmdicke 51 auf dem darunter befindlichen zuvor bereits strukturierten Abformfilm 25, der auf der Vorderseite 11 der Trägerfolie 10 aufliegt. Der Übertragungsfilm 50 wird hier als eine unter UV-Licht-Einwirkung transparent aushärtbare UV-Substratmasse 52 zur Verfügung gestellt.

**Fig. 6** zeigt im Detail die Ablösestation 6, in der die Verstärkungsfolie 15 von der Rückseite 12 der Trägerfolie 10 abgelöst wird. Dazu wird die Fixierung der Verstärkungsfolie 15 im Halterahmen 45 gelöst und es bleibt weiterhin nur mehr die Trägerfolie 10 im Halterahmen 45 eingespannt.

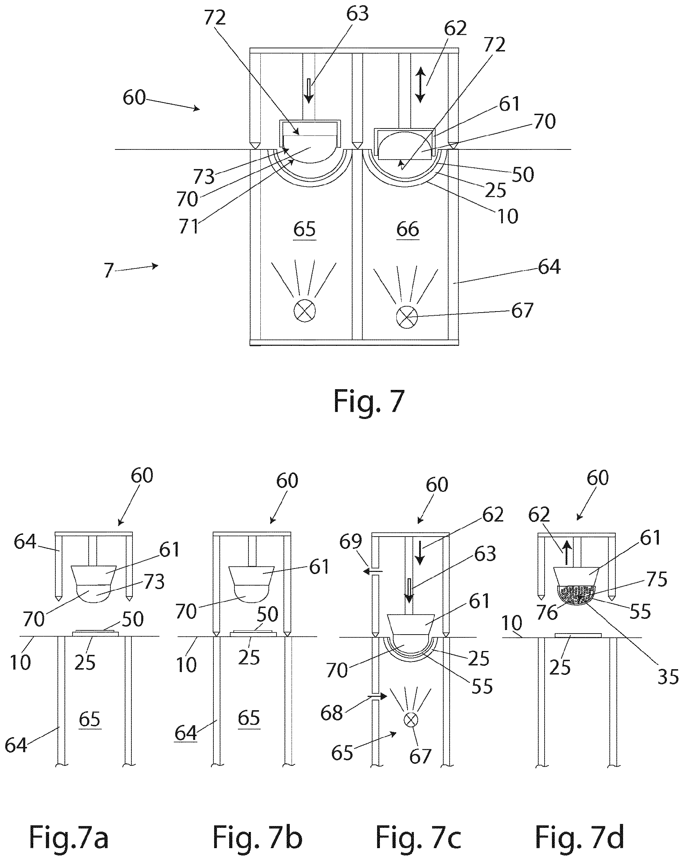

**Fig. 7** zeigt im Detail die in Fig. 1 dargestellte Übertragungsstation 7. Die Übertragungsstation 7 weist eine Übertragungseinrichtung 60 auf, die eine Bauteilhalterung 61 zur Aufnahme und Fixierung eines zu strukturierenden optischen Werkstücks 70 umfasst. Die Bauteilhalterung 61 ist mit einem höhenverstellbaren Stempel 62 ausgerüstet, wobei die Verstellrichtung des Stempels als Doppelpfeil 62 symbolisiert ist. Der verstellbare bzw. verfahrbare Stempel 62 der Bauteilhalterung 61 kann mit einem Anpressdruck 63 in lotrechter Richtung zur Trägerfolie 10 gedrückt werden. Der Anpressdruck 63 ist durch einen Pfeil 63 symbolisiert. Die Übertragungseinrichtung 60 weist weiters ein Gehäuse 64 auf und umfasst hier eine erste Belichtungskammer 65 sowie eine zweite Belichtungskammer 66, die jeweils mit einer Bauteilhalterung 61 und einem zugehörigen höhenverstellbaren Stempel 62 ausgestattet sind. Jede der Belichtungskammern 65, 66 weist jeweils eine UV-Lichtquelle 67 auf. In dieser Ausführung kann beispielsweise ein optisches Werkstück 70 zuerst in der ersten Belichtungskammer 65 mit einer (Sub-)Mikrostruktur 35 an seiner Vorderseite 71 strukturiert werden und - nach entsprechendem Wenden des optischen Werkstücks 70 in der Bauteilhalterung 61 - anschließend in der zweiten Belichtungskammer 66 an seiner Rückseite 72 oder einem weiteren gewölbten Oberflächenabschnitt 73 mit einer gleichartigen oder unterschiedlichen (Sub-)Mikrostruktur 35 strukturiert werden.

**Fig. 7A** zeigt im Detail das Bestücken einer Übertragungsstation. Die hier gezeigte Übertragungseinrichtung 60 weist ein Gehäuse 64 auf und umfasst beispielsweise eine Belichtungskammer 65. Das Gehäuse 64 ist in Fig. 7A geöffnet dargestellt. Eine Bauteilhalterung 61 mit einem darin befestigten zu strukturierenden optischen Werkstück 70 befindet sich in angehobener Position in einem Abstand oberhalb der Trägerfolie 10. Auf der Trägerfolie liegt ein bereits strukturierter Abformfilm 25 auf. Der Abformfilm 25 weist eine Negativform der (Sub-)Mikrostruktur 35 des Modellobjekts 30 auf. Diese Negativform des Abformfilms 50 ist mit einem Übertragungsfilm 50 beschichtet bzw. aufgefüllt.

**Fig. 7B** zeigt im Detail die in Fig. 7A gezeigte Übertragungsstation in geschlossener Lage. das zu strukturierende optische Werkstück 70 befindet sich an der Bauteilhalterung 61 noch in angehobener Position in einem Abstand oberhalb der Trägerfolie 10. Das Gehäuse 64 der Belichtungskammer 65 ist bereits geschlossen.

**Fig. 7C** stellt im Detail das Abformen und Übertragen der (Sub-)Mikrostruktur auf den optischen Bauteil anhand der in den Figuren 7A und 7B gezeigten Übertragungsstation dar. Dazu wird das zu strukturierende optische Werkstück 70 auf den mit dem Übertragungsfilm 50 beschichteten strukturierten Abformfilm 25 gepresst, der sich an der Vorderseite 11 bzw. der Oberseite der Trägerfolie 10 befindet. Zum Anpressen wird das in der Bauteilhalterung 61 eingespannte optische Werkstück 70 mit einem Anpressdruck 63 lotrecht auf die Trägerfolie 10 bzw. auf den auf dem strukturierten Abformfilm 25 darauf befindlichen Übertragungsfilm 50 gepresst. Durch das Anpressen wird die Struktur des strukturierten Abformfilms als Negativform der (Sub-)Mikrostruktur des Modellobjekts auf den flüssigen bzw. fließfähigen Übertragungsfilm 50 abgeformt und solcherart ein strukturierter Übertragungsfilm 55 erhalten. Zum Aushärten des noch flüssigen bzw. fließfähigen strukturierten Übertragungsfilms 55, der an einem Oberflächenabschnitt des zu strukturierenden optischen Werkstücks 70 anhaftet, wird UV-Licht 67 eingesetzt. Als Material des Übertragungsfilms ist hier ein unter UV-Licht-Einwirkung transparent aushärtender Haftklebstoff, beispielsweise ein flüssiges UV-Acrylat, eingesetzt.

In der Übertragungsstation wird dieser Haftklebstoff unter UV-Licht-Einwirkung beispielsweise während einer Zeitdauer von einer Minute bei einer erhöhten Temperatur von 80°C bis 120°C ausgehärtet. Um den Anpressdruck auf den gewölbten Oberflächenabschnitt 73 des optischen Werkstücks 70 während des Press- und Abformvorgangs zu vergleichmäßigen, wird das Anpressen - symbolisiert als Pfeil 63 für den Anpressdruck 63 - des zu strukturierenden optischen Werkstücks 70 auf den mit dem Übertragungsfilm 50 beschichteten strukturierten Abformfilm 25 zusätzlich durch Erzeugen von Überdruck 68 an der Rückseite 12 der Trägerfolie 10 sowie durch Erzeugen von Unterdruck 69, vorzugsweise durch Evakuieren, an der Vorderseite 11 der Trägerfolie 10 weiter unterstützt. Ein Pfeil 68 symbolisiert die Druckluftzuleitung 68 zur Erzeugung von Überdruck 68. Ein Pfeil 69 symbolisiert die Unterdrucksaugleitung 69 zur Erzeugung von Unterdruck bzw. von Vakuum.

**Fig. 7D** zeigt die in den Figuren 7A bis 7C veranschaulichte Übertragungsstation während des Entleerens des fertig strukturierten optischen Bauteils. Dazu wird das Gehäuse 64 der Belichtungskammer 65 wieder geöffnet und der höhenverstellbare Stempel der Bauteilhalterung 61 in Pfeilrichtung 62 von der Trägerfolie 10 weg nach oben bewegt. Der Bauteilhalterung 61 kann anschließend ein mit (Sub-)Mikrostrukturen 35 strukturierter optischer Bauteil 75 entnommen werden. Der fertig strukturierte optische Bauteil 75 weist einen gekrümmten Oberflächenabschnitt 76 auf, auf dem der mit der (Sub-)Mikrostruktur 35 strukturierte Übertragungsfilm 55 aufgebracht ist.

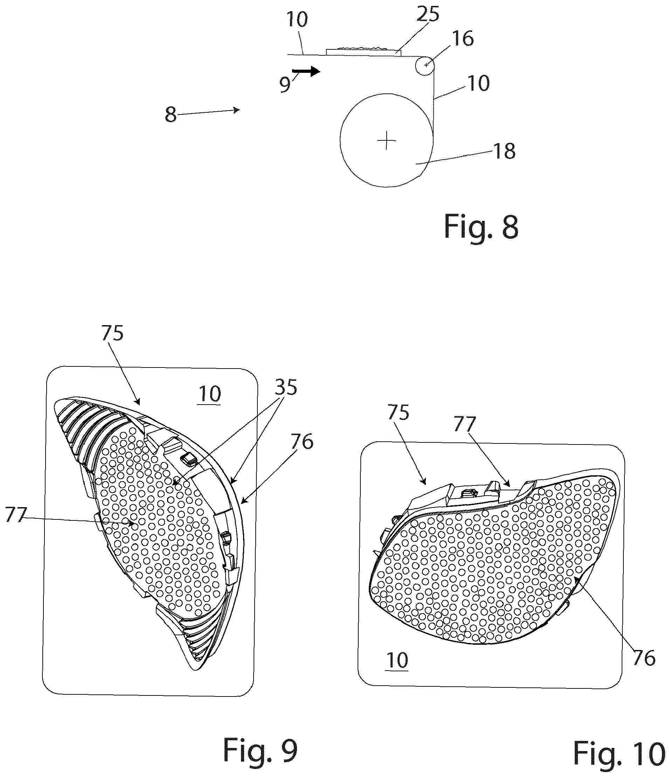

**Fig. 8** zeigt in einer Detailansicht die in Fig. 1 gezeigte Aufwickelstation 8. In dieser Aufwickelstation 8 wird der strukturierte Abformfilm 25 von der Trägerfolie 10 abgenommen und die Trägerfolie 10 anschließend auf einer Sammelrolle 18 aufgerollt.

**Fig. 9** zeigt in einer isometrischen Ansicht schräg von oben einen mit (Sub-)Mikrostrukturen 35 strukturierten optischen Bauteil 75 kurz vor dem Abnehmen von der Trägerfolie 10. Der optische Bauteil 75 weist hier an seiner Vorderseite einen ersten strukturierten gewölbten Oberflächenabschnitt 76 sowie an seiner Rückseite einen zweiten strukturierten Oberflächenabschnitt 77 auf.

**Fig. 10** den in Fig. 9 gezeigten fertig strukturierten optischen Bauteil 75 in einer Ansicht schräg von vorne nach dem Abnehmen von der Trägerfolie 10.

### LISTE DER BEZUGSZEICHEN

- 1: Vorrichtung zur Herstellung von (Sub-)Mikrostrukturen auf gewölbten Flächen
- 2: Abwickelstation
- 3: Dosierstation für Abformfilm
- 4: Prägestation
- 5: Dosierstation für UV-Substratmasse
- 6: Ablösestation
- 7: Übertragungsstation
- 8: Aufwickelstation
- 9: Transportrichtung (Pfeil)
- 10: Trägerfolie
- 11: Vorderseite der Trägerfolie
- 12: Rückseite der Trägerfolie
- 14: Trägerfolienrolle
- 15: Verstärkungsfolie
- 16: Umlenkrolle
- 17: Verstärkungsfolienrolle
- 18: Sammelrolle
- 20: Abformfilm
- 21: Filmdicke des Abformfilms
- 22: Abformmasse
- 25: mit einem Abdruck der (Sub-)Mikrostruktur strukturierter Abformfilm
- 30: Modellobjekt
- 35: (Sub-)Mikrostruktur
- 40: Prägeeinrichtung
- 41: Prägedruck (Pfeil)
- 45: Halterahmen
- 50: Übertragungsfilm
- 51: Filmdicke des Übertragungsfilms
- 52: UV-Substratmasse
- 55: mit der (Sub-)Mikrostruktur strukturierter Übertragungsfilm
- 60: Übertragungseinrichtung
- 61: Bauteilhalterung
- 62: Höhenverstellbarer Stempel der Bauteilhalterung (Doppelpfeil)
- 63: Anpressdruck der Bauteilhalterung (Pfeil)
- 64: Gehäuse der Übertragungseinrichtung
- 65: erste Belichtungskammer
- 66: zweite Belichtungskammer
- 67: UV-Lichtquelle
- 68: Druckluft (Pfeil)
- 69: Unterdruck bzw. Vakuum (Pfeil)
- 70: optisches Werkstück
- 71: Vorderseite des optischen Werkstücks
- 72: Rückseite des optischen Werkstücks
- 73: gewölbte Oberfläche bzw. Oberflächenabschnitt des optischen Werkstücks
- 75: mit (Sub-)Mikrostrukturen strukturierter optischer Bauteil
- 76: erster Oberflächenabschnitt des strukturierten optischen Bauteils
- 77: zweiter Oberflächenabschnitt des strukturierten optischen Bauteils

## Patentansprüche

1. Verfahren zur Herstellung von (Sub-)Mikrostrukturen auf gewölbten Flächen eines optischen Bauteils, **gekennzeichnet durch** die folgenden Verfahrensschritte:
-a- Bereitstellen einer elastischen Trägerfolie (10) mit einer von der Trägerfolie (10) ablösbaren Verstärkungsfolie (15);
-b- Bereitstellen eines Modellobjekts (30) mit einer (Sub-)Mikrostruktur (35);
-c- Auftragen eines Abformfilms (20) auf der der Verstärkungsfolie (15) abgewandten Vorderseite (11) der Trägerfolie (10);
-d- Abformen der (Sub-)Mikrostruktur (35) des Modellobjekts (30) auf die mit dem Abformfilm (20) beschichtete Vorderseite (11) der Trägerfolie (10) unter Bildung eines strukturierten Abformfilms (25);
-e- Einspannen der mit dem strukturierten Abformfilm (25) beschichteten Trägerfolie (10) samt der Verstärkungsfolie (15) in einem Halterahmen (45);
-f- Auftragen eines aushärtbaren Übertragungsfilms (50) auf die mit dem strukturierten Abformfilm (25) beschichtete Vorderseite (11) der Trägerfolie (10);
-g- Ablösen der Verstärkungsfolie (15) von der Rückseite (12) der Trägerfolie (10);
-h- Anpressen zumindest eines Oberflächenabschnittes (73) eines zu strukturierenden optischen Werkstücks (70) auf den mit dem Übertragungsfilm (50) beschichteten strukturierten Abformfilm (25) an der Vorderseite (11) der Trägerfolie (10) unter Bildung eines strukturierten Übertragungsfilms (55);
-i- Aushärten des an dem zumindest einen Oberflächenabschnitt (73) des optischen Werkstücks (70) anhaftenden strukturierten Übertragungsfilms (55) unter Bildung eines mit (Sub-)Mikrostrukturen (35) strukturierten optischen Bauteils (75);
-j- Abnehmen des strukturierten optischen Bauteils (75) von dem auf der Trägerfolie (10) verbleibenden strukturierten Abformfilm (25).

2. Verfahren nach Anspruch 1, **dadurch gekennzeichnet, dass** die elastische Trägerfolie (10) samt der daran ablösbar angeordneten Verstärkungsfolie (15) als Rollenware bereitgestellt werden.

3. Verfahren nach Anspruch 2, **dadurch gekennzeichnet, dass** die Verstärkungsfolie (15) und die Trägerfolie (10) nach Gebrauch getrennt voneinander aufgerollt und gegebenenfalls wiederverwendet werden können.

4. Verfahren nach einem der Ansprüche 1 bis 3, **dadurch gekennzeichnet, dass** die elastische Trägerfolie (10) aus einem Silikonkautschuk-Material, vorzugsweise aus Polydimethylsiloxan, gefertigt ist.

5. Verfahren nach einem der Ansprüche 1 bis 4, **dadurch gekennzeichnet, dass** das Modellobjekt (30) zumindest in seinem mit der (Sub-)Mikrostruktur (35) versehenen Konturabschnitt im Wesentlichen eben ist.

6. Verfahren nach einem der Ansprüche 1 bis 5, **dadurch gekennzeichnet, dass** der Abformfilm (20) aus einer Abformmasse (22) enthaltend ein Silikonkautschuk-Material, vorzugsweise ein additionsvernetzendes Zwei-Komponenten-Silikonkautschuk-Material, gebildet wird.

7. Verfahren nach einem der Ansprüche 1 bis 6, **dadurch gekennzeichnet, dass** die (Sub-)Mikrostruktur (35) des Modellobjekts (30) auf den Abformfilm (20) geprägt wird, wobei das Aufprägen vorzugsweise während einer Zeitdauer von zumindest 30 Sekunden bei gegenüber der Raumtemperatur erhöhter Temperatur, besonders bevorzugt bei einer Temperatur von 70°C bis 140°C, erfolgt.

8. Verfahren nach einem der Ansprüche 1 bis 7, **dadurch gekennzeichnet, dass** das Anpressen des zumindest einen Oberflächenabschnittes (73) des zu strukturierenden optischen Werkstücks (70) auf den mit dem Übertragungsfilm (50) beschichteten strukturierten Abformfilm (25) durch Erzeugen von Überdruck (68) an der Rückseite (12) der Trägerfolie (10) und/oder durch Erzeugen von Unterdruck (69), vorzugsweise durch Evakuieren, an der Vorderseite (11) der Trägerfolie (10) erfolgt.

9. Verfahren nach einem der Ansprüche 1 bis 8, **dadurch gekennzeichnet, dass** das Aushärten des an dem zumindest einen Oberflächenabschnitt (73) des optischen Werkstücks (70) anhaftenden strukturierten Übertragungsfilms (55) unter Einwirkung von UV-Licht (67) vorzugsweise während einer Zeitdauer von zumindest 30 Sekunden bei gegenüber der Raumtemperatur erhöhter Temperatur, besonders bevorzugt bei einer Temperatur von 70°C bis 140°C, erfolgt.

10. Verfahren nach einem der Ansprüche 1 bis 9, **dadurch gekennzeichnet, dass** der Übertragungsfilm (50) aus einem unter UV-Licht-Einwirkung transparent aushärtenden Haftklebstoff, vorzugsweise aus einem flüssigen UV-Acrylat, gebildet wird.

## Claims

1. Method for producing (sub)microstructures on curved surfaces of an optical component, **characterized by** the following method steps:
- a- providing an elastic carrier foil (10) with a reinforcing foil (15) detachable from the carrier foil (10);
- b- providing a model object (30) having a (sub)microstructure (35);
- c- applying an impression film (20) to the front side (11) of the carrier foil (10) facing away from the reinforcing foil (15);
- d- molding the (sub-)microstructure (35) of the model object (30) onto the front side (11) of the carrier foil (10) coated with the impression film (20), forming a structured impression film (25);
- e- clamping the carrier foil (10) coated with the structured impression film (25) together with the reinforcing foil (15) in a holding frame (45);
- f- applying a curable transfer film (50) to the front side (11) of the carrier foil (10) coated with the structured impression film (25);
- g- peeling off the reinforcing foil (15) from the back side (12) of the carrier foil (10);
- h- pressing at least a surface portion (73) of an optical workpiece (70) to be structured onto the structured impression film (25) coated with the transfer film (50) on the front side (11) of the carrier foil (10) to form a structured transfer film (55);
- i- curing the structured transfer film (55) adhering to the at least one surface portion (73) of the optical workpiece (70) to form an optical component (75) structured with (sub)microstructures (35);
- j- removing the structured optical component (75) from the structured transfer film (25) remaining on the carrier foil (10).

2. Method according to claim 1, **characterized in that** the elastic carrier foil (10) together with the reinforcing foil (15) detachably arranged thereon are provided as roll material.

3. Method according to claim 2, **characterized in that** the reinforcing foil (15) and the carrier foil (10) can be rolled up separately from one another after use and reused if necessary.

4. Method according to any one of claims 1 to 3, **characterized in that** the elastic carrier foil (10) is made of a silicone rubber material, preferably polydimethylsiloxane.

5. Method according to any one of claims 1 to 4, **characterized in that** the model object (30) is substantially planar at least in its contour section provided with the (sub)microstructure (35).

6. Method according to one of claims 1 to 5, **characterized in that** the impression film (20) is formed from an impression compound (22) containing a silicone rubber material, preferably an addition-curing two-component silicone rubber material.

7. Method according to any one of claims 1 to 6, **characterized in that** the (sub-)microstructure (35) of the model object (30) is embossed onto the impression film (20), the embossing preferably taking place for a period of at least 30 seconds at a temperature elevated with respect to room temperature, particularly preferably at a temperature of 70°C to 140°C.

8. Method according to one of claims 1 to 7, **characterized in that** the pressing of the at least one surface portion (73) of the optical workpiece (70) to be structured onto the structured impression film (25) coated with the transfer film (50) is carried out by generating positive pressure (68) on the back side (12) of the carrier foil (10) and/or by generating negative pressure (69), preferably by evacuation, on the front side (11) of the carrier foil (10).

9. Method according to any one of claims 1 to 8, **characterized in that** the curing of the structured transfer film (55) adhering to the at least one surface portion (73) of the optical workpiece (70) takes place under the action of UV light (67) preferably for a period of at least 30 seconds at a temperature elevated with respect to room temperature, particularly preferably at a temperature of 70°C to 140°C.

10. Method according to any one of claims 1 to 9, **characterized in that** the transfer film (50) is formed from a pressure-sensitive adhesive that cures transparently under the action of UV light, preferably from a liquid UV acrylate.

## Revendications

1. Procédé de fabrication de (sub)microstructures sur des surfaces bombées d'un composant optique, **caractérisé par** les étapes de procédé suivantes :
- a- mise à disposition d'une feuille de support élastique (10) avec une feuille de renforcement (15) détachable de la feuille de support (10) ;
- b- mise à disposition d'un objet modèle (30) avec une (sub)microstructure (35) ;
- c- application d'un film de moulage (20) sur la face avant (11) de la feuille de support (10) opposée à la feuille de renforcement (15) ;
- d- moulage de la (sub)microstructure (35) de l'objet modèle (30) sur la face avant (11) de la feuille de support (10) revêtue du film de moulage (20) en formant un film de moulage structuré (25) ;
- e- serrage de la feuille de support (10) revêtue du film de moulage structuré (25) avec la feuille de renforcement (15) dans un cadre de maintien (45) ;
- f- application d'une la feuille de transfert durcissable (50) sur la face avant (11) de la feuille de support (10) revêtue du film de moulage structuré (25) ;
- g- décollement de la feuille de renforcement (15) de la face arrière (12) de la feuille de support (10) ;
- h- pressage d'au moins une partie de surface (73) d'une pièce optique (70) à structurer sur le film de moulage structuré (25) revêtu de la feuille de transfert (50) sur la face avant (11) de la feuille de support (10) en formant une la feuille de transfert structuré (55) ;
- i- durcissement de la feuille de transfert structuré (55) adhérant de ladite au moins une partie de surface (73) de la pièce optique (70) en formant un composant optique (75) structuré avec des (sub)microstructures (35) ;
- j- décollement du composant optique structuré (75) de la feuille de transfert structuré (25) restant sur la feuille de support (10).

2. Procédé selon la revendication 1, **caractérisé en ce que** la feuille de support élastique (10) incluant la feuille de renforcement (15) disposé de manière amovible sur celui-ci sont mis à disposition sous forme de rouleau.

3. Procédé selon la revendication 2, **caractérisé en ce que** la feuille de renforcement (15) et la feuille de support (10) peuvent être enroulées séparément après utilisation et éventuellement réutilisées.

4. Procédé selon l'une quelconque des revendications 1 à 3, **caractérisé en ce que** la feuille de support élastique (10) est réalisée en un matériau de type caoutchouc silicone, de préférence en polydiméthylsiloxane.

5. Procédé selon l'une quelconque des revendications 1 à 4, **caractérisé en ce que** l'objet modèle (30) est sensiblement plan au moins dans sa portion de contour pourvue de la (sub)microstructure (35).

6. Procédé selon l'une quelconque des revendications 1 à 5, **caractérisé en ce que** le film de moulage (20) est formé à partir d'une masse de moulage (22) contenant un matériau de caoutchouc silicone, de préférence un matériau de caoutchouc silicone à deux composants réticulant par addition.

7. Procédé selon l'une quelconque des revendications 1 à 6, **caractérisé en ce que** la (sub)microstructure (35) de l'objet modèle (30) est estampée sur le film de moulage (20), ledit estampage s'effectuant de préférence pendant une durée d'au moins 30 secondes à une température élevée par rapport à température ambiante, de manière particulièrement préférée à une température de 70°C à 140°C.

8. Procédé selon l'une quelconque des revendications 1 à 7, **caractérisé en ce que** le pressage de ladite au moins une partie de surface (73) de la pièce optique (70) à structurer sur le film de moulage structuré (25) revêtu de la feuille de transfert (50) est réalisé en générant une surpression (68) sur la face arrière (12) de la feuille de support (10) et/ou en générant une dépression (69), de préférence par mise sous vide, sur la face avant (11) de la feuille de support (10).

9. Procédé selon l'une quelconque des revendications 1 à 8, **caractérisé en ce que** le durcissement de la feuille de transfert structuré (55) adhérant à ladite au moins une partie de surface (73) de la pièce optique (70) s'effectue sous l'effet de la lumière UV (67), de préférence pendant une durée d'au moins 30 secondes, à une température élevée par rapport à température ambiante, de manière particulièrement préférée à une température de 70°C à 140°C.

10. Procédé selon l'une quelconque des revendications 1 à 9, **caractérisé en ce que** la feuille de transfert (50) est formé d'un adhésif sensible à la pression durcissant sous l'action de la lumière UV en devenant transparente, de préférence d'un acrylate UV liquide.
